# EUROPEAN PATENT APPLICATION

(11) **EP 3 441 820 A1**
(43) Date of publication of application: **13.02.2019**
(21) Application number: 17185893.9
(22) Date of filing: 11.08.2017
(51) Int. Cl.: G03F 7/20, G01N 21/47, G01N 21/956, H05G 2/00

(54) **METHODS AND APPARATUS FOR DETERMINING THE POSITION OF A SPOT OF RADIATION AND INSPECTION APPARATUS**

(71) Applicant: ASML Netherlands B.V., 5500 AH Veldhoven (NL)
(72) Inventor: VAN VOORST, Peter, Danny, 5500 AH Veldhoven (NL); TUKKER, Teunis, Willem, 5500 AH Veldhoven (NL); LIN, Nan, 5500 AH Veldhoven (NL)
(74) Representative: Willekens, Jeroen Pieter Frank

(57) **Abstract**

A beam (542, 556) of soft x-ray (SXR) radiation is generated by focusing infrared (IR) radiation (540) at a source location so as to generate the SXR radiation (542) by higher harmonic generation in a gas cell (532). An illumination optical system (512) focuses the SXR radiation into a spot (S) of radiation by imaging the source location onto a metrology target (T). To determine the location of the spot of SXR radiation, the same illumination optical system is used to form a spot of the IR radiation onto an alignment target material. A spot of visible radiation is generated by second harmonic generation in an interaction between the IR radiation and the alignment target material. The visible spot is observed by an alignment camera (564). A special alignment target (592) may be provided, or material present in or near the metrology target can be used.

## Description

### FIELD

The present disclosure relates to methods and apparatus for inspection (e.g., metrology) usable, for example, in the manufacture of devices by lithographic techniques and to methods of manufacturing devices using lithographic techniques.

### BACKGROUND

A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g., including part of, one, or several dies) on a substrate (e.g., a silicon wafer). Transfer of the pattern is typically via imaging onto a layer of radiation-sensitive material (resist) provided on the substrate. In general, a single substrate will contain a network of adjacent target portions that are successively patterned. These target portions are commonly referred to as "fields".

In lithographic processes, it is desirable frequently to make measurements of the structures created, e.g., for process control and verification. Various tools for making such measurements are known, including scanning electron microscopes, which are often used to measure critical dimension (CD), and specialized tools to measure overlay, the accuracy of alignment of two layers in a device. Recently, various forms of scatterometers have been developed for use in the lithographic field. These devices direct a beam of radiation onto a target and measure one or more properties of the scattered radiation - e.g., intensity at a single angle of reflection as a function of wavelength; intensity at one or more wavelengths as a function of reflected angle; or polarization as a function of reflected angle - to obtain a diffraction "spectrum" from which a property of interest of the target can be determined.

Examples of known scatterometers include angle-resolved scatterometers of the type described in US2006033921A1 and US2010201963A1. The targets used by such scatterometers are relatively large, e.g., 40µm by 40µm, gratings and the measurement beam generates a spot that is smaller than the grating (i.e., the grating is underfilled). In addition to measurement of feature shapes by reconstruction, diffraction based overlay can be measured using such apparatus, as described in published patent application US2006066855A1. An overlay measurement is typically obtained by measuring asymmetry of two overlay gratings, each having a different programmed (deliberate) offset or "bias". Diffraction-based overlay metrology using dark-field imaging of the diffraction orders enables overlay measurements on smaller targets. Examples of dark field imaging metrology can be found in published patent applications US2014192338 and US2011069292A1. Further developments of the technique have been described in several published patent publications. These targets can be smaller than the illumination spot and may be surrounded by product structures on a wafer. Multiple gratings can be measured in one image, using a composite grating target. These developments have allowed the overlay measurements that are fast and computationally very simple (once calibrated).

At the same time, the known dark-field imaging techniques employ radiation in the visible or ultraviolet waveband. This limits the smallest features that can be measured, so that the technique can no longer measure directly the smallest features made in modern lithographic processes. To allow measurement of smaller structures, it has been proposed to use radiation of shorter wavelengths, similar for example to the extreme ultraviolet (EUV) wavelengths used in EUV lithography. Such wavelengths may also be referred to as soft x-ray wavelengths, and may be in the range 1 to 100 nm, for example. Examples of transmissive and reflective metrology techniques using these wavelengths in transmissive and/or reflective scattering modes are disclosed in published patent application WO2015172963A1. Further examples of metrology techniques and apparatuses using these wavelengths in transmissive and/or reflective scattering modes are disclosed in the published patent application US 2017045823 A1 and WO2017025392A1. The contents of all these applications are incorporated herein by reference.

Convenient sources of SXR radiation include higher harmonic generation (HHG) sources, in which infrared pump radiation from a laser is converted to shorter wavelength radiation by interaction with a gaseous medium. HHG sources are available for example from KMLabs, Boulder Colorado, USA (http://www.kmlabs.com/). Various modifications of HHG sources are also under consideration for application in inspection apparatus for lithography. Some of these modifications are disclosed for example in European patent application number 16198346.5 dated November 11, 2016, not published at the priority date of the present application. Other modifications are disclosed in US patent application US2017184511A1. The contents of both of these applications are incorporated herein by reference. HHG sources are not the only types of source in which the techniques of the present disclosure can be applied. Another type of source is the inverse Compton scattering (ICS) source, described in application WO2017025392A1, mentioned above. In that type of source, an electron beam is the "medium" in which laser light is converted to SXR or X-ray radiation. Another type of source is the laser-produced plasma (LPP) source, in which metal targets (often in the form of a mist or vapor) are used as the medium.

No single metrology technique meets all requirements, and hybrid metrology systems have been proposed to combine different types of measurement and different wavelengths in a compact and cost-effective system. Examples of such hybrid techniques are disclosed in patent application US 2017184981 A1.

The cost and other limitations of optical systems compatible with SXR wavelengths make it commercially unattractive to implement imaging in a detection system of the inspection apparatus. Spectroscopic techniques do not require imaging. Reconstruction does not require imaging. Even in applications where imaging using SXR radiation is required, synthetic imaging (so-called lensless imaging) can be performed, using scattered radiation and computational techniques.

Measurement of a particular target requires one to know where the spot of SXR radiation is in two or three dimensions, and position the target of interest. Conventional inspection apparatuses use an alignment camera to observer the spot and position it on the target. In the absence of imaging optics, however, this presents a problem for metrology at short wavelengths. Synthetic imaging is computationally expensive and usually performed off-line. For these reasons, an alternative solution is for alignment of the SXR spot with a target in a high-volume manufacturing scenario. An available solution, in the case of an HHG source, is to observe a spot of the infrared pump radiation, that should be focused at the same point as the SXR radiation. It is difficult to achieve high accuracy in this way, however, because the profile of the infrared beam is large and diffuse, compared to the smaller spot of SXR radiation.

### SUMMARY OF THE INVENTION

The invention aims to improve the throughput of inspection apparatus operating with SXR wavelength radiation, where the speed advantages of dark-field imaging are not available.

The present invention in a first aspect provides an apparatus for determining the position of a spot of radiation, the apparatus comprising:
- a radiation source arrangement operable to focus first radiation at a source location so as to generate second radiation in a medium provided at the source location;
- an illumination optical system operable to focus said second radiation into said spot at a target location; and
- a spot position sensor for measuring the position of said spot,
wherein said spot position sensor is arranged to use said illumination optical system to form a focused spot of said first radiation onto an alignment target material and thereby to cause a spot of third radiation to be generated by second harmonic generation in an interaction between the first radiation and the alignment target material, the spot of third radiation being used to indicate the position of the spot of second radiation.

By exploiting a second harmonic generation (SHG) process in the alignment target material, a spot of second radiation is generated in the same location as the (SXR) second radiation, but at a wavelength in the IR or visible region that can be directly imaged. Because SHG is a non-linear process, the size of the spot can be made much smaller than the spot of first radiation, and therefore the position of the SXR spot can be inferred with much greater accuracy than by observing the first radiation directly.

The invention in a second aspect provides an inspection apparatus comprising:
- an apparatus according to the first aspect of the invention as set forth above, for delivering a spot of radiation to a target;
- a positioning system for holding a target at said target location by controlling of the relative position of the target and said spot, wherein said controlling is based at least partly on a position of the spot of third information detected by the spot position sensor; and
- a detection system arranged to detect, at one or more detection locations, portions of said second radiation that have interacted with a target structure positioned at said target location using said positioning system.

The inspection apparatus may be a scatterometer and/or reflectometer, for determining properties of the target structure, as CD or overlay.

The invention in a third aspect provides a method of determining the position of a spot of radiation without imaging the spot directly, the method comprising:
(a) focusing first radiation at a source location so as to generate second radiation in a medium provided at the source location;
(b) using an illumination optical system to focus said second radiation into said spot of radiation at a target location;
(c) using said illumination optical system to form a focused spot of said first radiation onto an alignment target material;
(d) detecting the position of a spot of third radiation generated by second harmonic generation in an interaction between the first radiation and the alignment target material; and
(e) using the detected position of the spot of third radiation as an indication of the position of the spot of second radiation.

The invention further provides a method of manufacturing devices, the method including a lithographic process step, wherein, before or after performing said lithographic process step, measurements are obtained of one or more target structures on a substrate whose position is controlled using the position of the spot of second radiation determined by a method according to the third aspect of the invention as set forth above, and wherein the obtained measurements are used to adjust parameters of the lithographic process step for the processing of the substrate and/or further substrates.

Further features and advantages, as well as the structure and operation of various embodiments, are described in detail below with reference to the accompanying drawings. It is noted that the invention is not limited to the specific embodiments described herein. Such embodiments are presented herein for illustrative purposes only. Additional embodiments will be apparent to persons skilled in the relevant art(s) based on the teachings contained herein.

### BRIEF DESCRIPTION OF THE DRAWINGS

Embodiments will now be described, by way of example only, with reference to the accompanying drawings in which:
Figure 1 depicts a lithographic apparatus together with other apparatuses forming a production facility for semiconductor devices, and including a hybrid metrology apparatus including an inspection apparatus according to an embodiment of the present invention;
Figure 2 shows a schematic general arrangement of metrology apparatuses in the production facility shown in Figure 1;
Figure 3 shows (a) a composite grating target and (b) a relationship between spot sizes of first radiation and second radiation in in an example inspection apparatus, illustrating the problem of target alignment;
Figure 4 shows (a) a graph of intensity in the spot of first radiation, relative to a second harmonic generation threshold and (b) a relationship between spot sizes of first radiation and third radiation, facilitating accurate target alignment in accordance with the principles of the present invention;
Figure 5 shows schematically (a) the arrangement of components in an example inspection apparatus in which the present invention may be applied, (b) part of a detection system in end view and (c) the detection system and alignment camera in plan view; and
Figure 6 is a flow chart illustrating a method of controlling performance of a metrology method and/or of a lithographic manufacturing process using measurements made by the hybrid metrology system of Figure 1.

### DETAILED DESCRIPTION OF EXEMPLARY EMBODIMENTS

Before describing embodiments of the invention in detail, it is instructive to present an example environment in which embodiments of the present invention may be implemented.

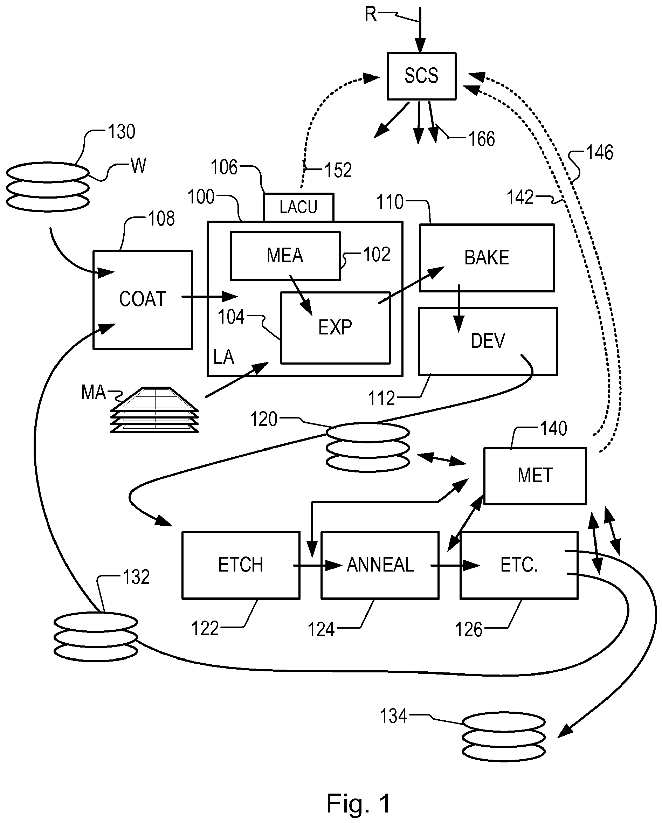

Figure 1 at 100 shows a lithographic apparatus LA as part of an industrial facility implementing a high-volume, lithographic manufacturing process. In the present example, the manufacturing process is adapted for the manufacture of for semiconductor products (integrated circuits) on substrates such as semiconductor wafers. The skilled person will appreciate that a wide variety of products can be manufactured by processing different types of substrates in variants of this process. The production of semiconductor products is used purely as an example which has great commercial significance today.

Within the lithographic apparatus (or "litho tool" 100 for short), a measurement station MEA is shown at 102 and an exposure station EXP is shown at 104. A control unit LACU is shown at 106. In this example, each substrate visits the measurement station and the exposure station to have a pattern applied. In an optical lithographic apparatus, for example, a projection system is used to transfer a product pattern from a patterning device MA onto the substrate using conditioned radiation and a projection system. This is done by forming an image of the pattern in a layer of radiation-sensitive resist material.

The term "projection system" used herein should be broadly interpreted as encompassing any type of projection system, including refractive, reflective, catadioptric, magnetic, electromagnetic and electrostatic optical systems, or any combination thereof, as appropriate for the exposure radiation being used, or for other factors such as the use of an immersion liquid or the use of a vacuum. The patterning MA device may be a mask or reticle, which imparts a pattern to a radiation beam transmitted or reflected by the patterning device. Well-known modes of operation include a stepping mode and a scanning mode. As is well known, the projection system may cooperate with support and positioning systems for the substrate and the patterning device in a variety of ways to apply a desired pattern to many target portions across a substrate. Programmable patterning devices may be used instead of reticles having a fixed pattern. The radiation for example may include electromagnetic radiation in the deep ultraviolet (DUV) or extreme ultraviolet (EUV) wavebands. The present disclosure is also applicable to other types of lithographic process, for example imprint lithography and direct writing lithography, for example by electron beam.

The lithographic apparatus control unit LACU controls all the movements and measurements of various actuators and sensors, causing the apparatus to receive substrates W and reticles MA and to implement the patterning operations. LACU also includes signal processing and data processing capacity to implement desired calculations relevant to the operation of the apparatus. In practice, control unit LACU will be realized as a system of many sub-units, each handling the real-time data acquisition, processing and control of a subsystem or component within the apparatus.

Before the pattern is applied to a substrate at the exposure station EXP, the substrate is processed in at the measurement station MEA so that various preparatory steps may be carried out. The preparatory steps may include mapping the surface height of the substrate using a level sensor and measuring the position of alignment marks on the substrate using an alignment sensor. The alignment marks are arranged nominally in a regular grid pattern. However, due to inaccuracies in creating the marks and also due to deformations of the substrate that occur throughout its processing, the marks deviate from the ideal grid. Consequently, in addition to measuring position and orientation of the substrate, the alignment sensor in practice must measure in detail the positions of many marks across the substrate area, if the apparatus is to print product features at the correct locations with very high accuracy.

The lithographic apparatus LA may be of a so-called dual stage type which has two substrate tables, each with a positioning system controlled by the control unit LACU. While one substrate on one substrate table is being exposed at the exposure station EXP, another substrate can be loaded onto the other substrate table at the measurement station MEA so that various preparatory steps may be carried out. The measurement of alignment marks is therefore very time-consuming and the provision of two substrate tables enables a substantial increase in the throughput of the apparatus. If the position sensor IF is not capable of measuring the position of the substrate table while it is at the measurement station as well as at the exposure station, a second position sensor may be provided to enable the positions of the substrate table to be tracked at both stations. When lithographic apparatus LA is of a so-called dual stage type which has two substrate tables, the exposure station and the measurement station may be distinct locations between which the substrate tables can be exchanged. This is only one possible arrangement, however, and the measurement station and exposure station need not be so distinct. For example, it is known to have a single substrate table, to which a measurement stage is temporarily coupled during the pre-exposure measuring phase. The present disclosure is not limited to either type of system.

Within the production facility, apparatus 100 forms part of a "litho cell" or "litho cluster" that contains also a coating apparatus 108 for applying photosensitive resist and other coatings to substrates W for patterning by the apparatus 100. At an output side of apparatus 100, a baking apparatus 110 and developing apparatus 112 are provided for developing the exposed pattern into a physical resist pattern. Between all of these apparatuses, substrate handling systems take care of supporting the substrates and transferring them from one piece of apparatus to the next. These apparatuses, which are often collectively referred to as the "track", are under the control of a track control unit which is itself controlled by a supervisory control system SCS, which also controls the lithographic apparatus via lithographic apparatus control unit LACU. Thus, the different apparatuses can be operated to maximize throughput and processing efficiency. Supervisory control system SCS receives recipe information R which provides in great detail a definition of the steps to be performed to create each patterned substrate.

Once the pattern has been applied and developed in the litho cell, patterned substrates 120 are transferred to other processing apparatuses such as are illustrated at 122, 124, 126. A wide range of processing steps is implemented by various apparatuses in a typical manufacturing facility. For the sake of example, apparatus 122 in this embodiment is an etching station, and apparatus 124 performs a post-etch annealing step. Further physical and/or chemical processing steps are applied in further apparatuses, 126, etc.. Numerous types of operation can be required to make a real device, such as deposition of material, modification of surface material characteristics (oxidation, doping, ion implantation etc.), chemical-mechanical polishing (CMP), and so forth. The apparatus 126 may, in practice, represent a series of different processing steps performed in one or more apparatuses.

As is well known, the manufacture of semiconductor devices involves many repetitions of such processing, to build up device structures with appropriate materials and patterns, layer-by-layer on the substrate. Accordingly, substrates 130 arriving at the litho cluster may be newly prepared substrates, or they may be substrates that have been processed previously in this cluster or in another apparatus entirely. Similarly, depending on the required processing, substrates 132 on leaving apparatus 126 may be returned for a subsequent patterning operation in the same litho cluster, they may be destined for patterning operations in a different cluster, or they may be finished products to be sent for dicing and packaging.

Each layer of the product structure requires a different set of process steps, and the apparatuses 126 used at each layer may be completely different in type. Further, even where the processing steps to be applied by the apparatus 126 are nominally the same, in a large facility, there may be several supposedly identical machines working in parallel to perform the step 126 on different substrates. Small differences in set-up or faults between these machines can mean that they influence different substrates in different ways. Even steps that are relatively common to each layer, such as etching (apparatus 122) may be implemented by several etching apparatuses that are nominally identical but working in parallel to maximize throughput. In practice, moreover, different layers require different etch processes, for example chemical etches, plasma etches, according to the details of the material to be etched, and special requirements such as, for example, anisotropic etching.

The previous and/or subsequent processes may be performed in other lithography apparatuses, as just mentioned, and may even be performed in different types of lithography apparatus. For example, some layers in the device manufacturing process which are very demanding in parameters such as resolution and overlay may be performed in a more advanced lithography tool than other layers that are less demanding. Therefore some layers may be exposed in an immersion type lithography tool, while others are exposed in a 'dry' tool. Some layers may be exposed in a tool working at DUV wavelengths, while others are exposed using EUV wavelength radiation.

In order that the substrates that are exposed by the lithographic apparatus are exposed correctly and consistently, it is desirable to inspect exposed substrates to measure properties such as overlay errors between subsequent layers, line thicknesses, critical dimensions (CD), etc. Accordingly a manufacturing facility in which litho cell LC is located also includes metrology system MET which receives some or all of the substrates W that have been processed in the litho cell. Metrology results are provided directly or indirectly to the supervisory control system (SCS) 138. If errors are detected, adjustments may be made to exposures of subsequent substrates, especially if the metrology can be done soon and fast enough that other substrates of the same batch are still to be exposed. Also, already exposed substrates may be stripped and reworked to improve yield, or discarded, thereby avoiding performing further processing on substrates that are known to be faulty. In a case where only some target portions of a substrate are faulty, further exposures can be performed only on those target portions which are good.

Also shown in Figure 1 is a metrology apparatus 140 which is provided for making measurements of parameters of the products at desired stages in the manufacturing process. A common example of a metrology apparatus in a modern lithographic production facility is a scatterometer, for example an angle-resolved scatterometer or a spectroscopic scatterometer, and it may be applied to measure properties of the developed substrates at 120 prior to etching in the apparatus 122. Using metrology apparatus 140, it may be determined, for example, that important performance parameters such as overlay or critical dimension (CD) do not meet specified accuracy requirements in the developed resist. Prior to the etching step, the opportunity exists to strip the developed resist and reprocess the substrates 120 through the litho cluster. As is also well known, the metrology results 142 from the apparatus 140 can be used to maintain accurate performance of the patterning operations in the litho cluster, by supervisory control system SCS and/or control unit LACU 106 making small adjustments over time, thereby minimizing the risk of products being made out-of-specification, and requiring re-work. Of course, metrology apparatus 140 and/or other metrology apparatuses (not shown) can be applied to measure properties of the processed substrates 132, 134, and incoming substrates 130.

Each generation of lithographic manufacturing technology (commonly referred to as a technology "node") has tighter specifications for performance parameters such as CD. One of the main challenges in metrology is that the size of features within the product and becomes smaller and smaller, and this smaller feature size should be reflected also in the design of metrology targets. Accordingly, metrology apparatus 140 may include an inspection apparatus designed to operate with radiation at wavelengths shorter than conventional visible or UV wavelengths. As a particular example, soft x-ray (SXR) radiation (also called extreme ultraviolet EUV radiation) radiation may be used, with wavelengths in the range 1-100 nm.

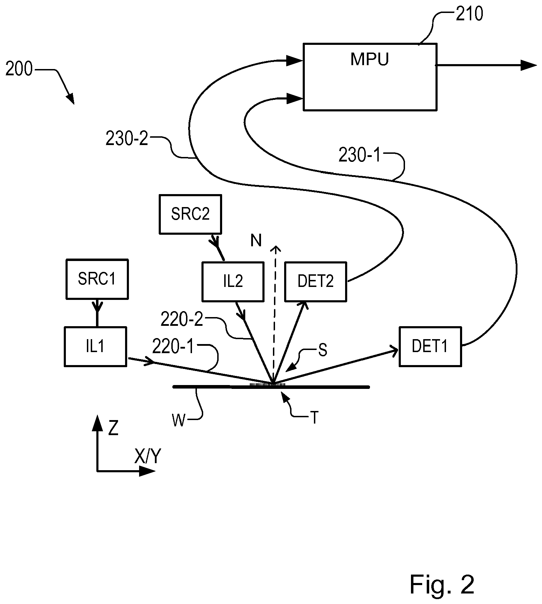

Figure 2 illustrates first and second inspection apparatuses which are provided, just for example, in a hybrid metrology system 200 of the type disclosed in US2017184981A1, mentioned above. Each inspection apparatus comprises a radiation source SRC1/SRC2, an illumination system IL1/IL2 and a detection system DET1/DET2. Of course, a single inspection apparatus can be provided, instead of a hybrid system. The metrology apparatuses may be integrated with either the lithographic apparatus LA itself or within the lithographic cell LC. Within a metrology processing unit MPU 210, data received from each of the detection systems DET1/DET2 is processed. MPU 210 may report these results separately, or may combine information from the individual inspection apparatus to obtain the measurement of the desired parameter of target structure T.

One or both of the first and second inspection apparatuses may be designed to operate with SXR radiation, of the same or different wavelengths. The radiation source SRC1/SRC2 may be for example a higher harmonic generation (HHG) source, in which a beam of infrared laser radiation interacts with an HHG medium as described further below.

In the example of Figure 2, the first inspection apparatus uses a first beam of inspection radiation 220-1 that has grazing incidence and is focused to form a spot S that is aligned with the target T. First captured data 230-1 is captured by first detection system DET1, as the first beam of inspection radiation interacts with the target T. The second inspection apparatus uses a second beam of inspection radiation 220-2 having a higher angle of incidence, and possibly having different wavelength characteristics and other properties. Second captured data 230-2 is captured by second detection system DET2, as the second beam of inspection radiation interacts with the target T. Each inspection apparatus may be a spectroscopic scatterometer, or an angle-resolved scatterometer, or an ellipsometer, or any kind of optical instrument. The figure suggests only the reflected beam of grazing incidence source IL1 being detected, the first detection system DET-1 may also detect the diffracted or scattered light from the target. One or other or both of the inspection apparatuses may use scattered radiation to calculate a synthetic image, as mentioned in the introduction. The detection systems for these applications will not generally include an imaging optical system.

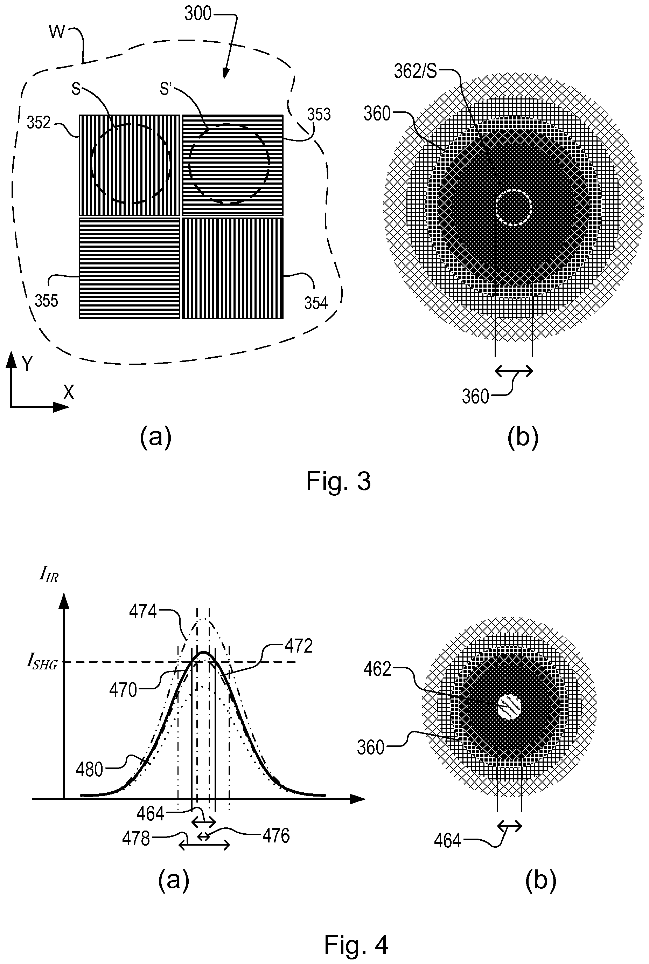

Figure 3 (a) shows an example of metrology targets. A composite grating target 300 is formed on wafer W in between product structures (not shown). The target 300 comprises four individual gratings 352, 353, 354, 355, which may be for example overlay gratings, formed in two layers. In one example, gratings 352 and 354 are X-direction overlay gratings with biases of the +d, -d, respectively. This means that grating 352 has its overlying components arranged so that if they were both printed exactly at their nominal locations one of the components would be offset relative to the other by a distance d. Grating 354 has its components arranged so that if perfectly printed it would be offset by the same distance d, but in the opposite direction to the first grating and so on. Gratings 353 and 355 are Y-direction overlay gratings with offsets +d and -d respectively.

An outline of spot S shows the diameter of the beam of inspection radiation (220-1 or 220-2) where it is focused at a target location. By arranging to move the substrate W relative to the inspection apparatus, spot S can be moved to a position S' for measuring target 353, and so on. In an example, the target grating 352, 353 etc. may have a dimension less than 10 µm across, for example approximately 5 µm. The spot S of SXR radiation may have a diameter of less than 10 µm, for example less than 5 µm, for example around 3 or 4 µm.

As mentioned, the detection system does not directly image the spot of SXR radiation, and so some other way of determining the position of the spot S needs to be provided, so that the spot S, S' etc. can be positioned accurately on the target 352, 353 etc.. In a case where synthetic imaging is performed, by the MPU 210, an image of the spot S could be obtained, but the calculation of the synthetic image is time-consuming, and the measure-acquire-measure cycle in a high-volume production facility needs to be made as short as possible, to allow hundreds or even thousands of measurements to be made per hour.

Figure 3 (b) shows a relationship between spot sizes of the infrared first radiation and second radiation in an example inspection apparatus using an HHG source. Although the SXR radiation is not directly imaged, it is possible to allow some of the infrared pump radiation to be focused at the same time as the SXR radiation generated by HHG. As the illumination optical system IL1/IL2 uses reflective optics for focusing, a spot of this infrared (IR) radiation will be focused at the same target location as the SXR radiation. Conventional imaging optics can then be used to observe this infrared spot on the target, as a way of determining the location of the SXR spot. Unfortunately, the beam of infrared pump radiation is generally much wider than the SXR radiation, being perhaps several tens of µm wide. Due to the fact the infrared beam is Gaussian, we know the SXR spot will be generated exactly in the center of the beam, where intensity is highest. However, due to the fact it is a Gaussian beam, the edge will not be imaged sharply. The large, diffuse area 360 in Figure 3(b) represents schematically the extent of the infrared spot, while the dotted circle 362 represents the extent of the corresponding spot of SXR radiation, which has a nominal diameter indicated at 364. It will be hard to find the center of such a blurry spot of the size of the IR beam within micron accuracy and precision. It follows that an observation of the infrared spot cannot provide a very accurate position for the smaller spot of SXR radiation.

In accordance with the principles of the present disclosure, we propose to use the IR radiation for alignment, but to use a nonlinear effect called 'second harmonic generation' (SHG) or 'two-photon absorption'. In this process, two photons of IR light are converted to a single photon with half the wavelength. With an IR radiation wavelength around 1000 nm (1 µm), the generated photon will have a wavelength of ∼500 nm, which sits comfortably in the visible band and allows easy detection. As will now be explained, the spot of visible radiation can be made of arbitrarily small size, to allow accurate detection of the center of the IR spot, and hence the position of the SXR spot, too.

Figure 4 (a) shows a graph of intensity *I_{IR}* in the spot of infrared radiation, relative to a second harmonic generation threshold *I_{SHG}.* Figure 4 (b) shows a relationship between spot sizes of the infrared radiation (area 360 again) and a spot 462 of visible radiation generated by second harmonic generation (SHG). The generation of the second harmonic is, as a nonlinear process, dependent on the intensity of the incoming light. Since the incoming light has a Gaussian intensity profile, second harmonic generation (SHG) will only take place at the position within the beam where the intensity of radiation is highest. For a Gaussian beam this location will be at the center of the beam. Even for a non-ideal beam profile, the highest intensity will be associated with the generation of HHG and SHG radiation. With an IR beam profile as indicated by the solid curve 470, the threshold for SHG is exceeded over a width labelled 464 at the center of the beam. This width corresponds then to the diameter of the SHG spot 462. By tuning the intensity of the IR beam down (curve 472) or up (curve 474) with respect to the threshold *I_{SHG}* the size of the SHG spot can be made smaller (diameter 476) or larger (diameter 478). If the peak intensity is below the threshold (curve 480), then no SHG will occur, and the spot 462 of visible light will be absent.

The threshold *I_{SHG}* for second harmonic generation depends on the target material and other conditions including, for example, the laser radiation wavelength and polarization, and crystal orientation within the target material. Different mechanisms can be involved. Special nonlinear optical materials (for example KTP potassium titanyl phosphate or LiNbO₃), if present, will naturally give rise to second harmonic generation within a crystal of that material. However, SHG can also arise at the surface of less exotic materials, such as metals, SiO₂ and other materials generally present on a semiconductor substrate. These materials might be present within the target T (300) or nearby. If the materials have an etched structure, the increased surface area can enhance the SHG process, compared with a planar surface.

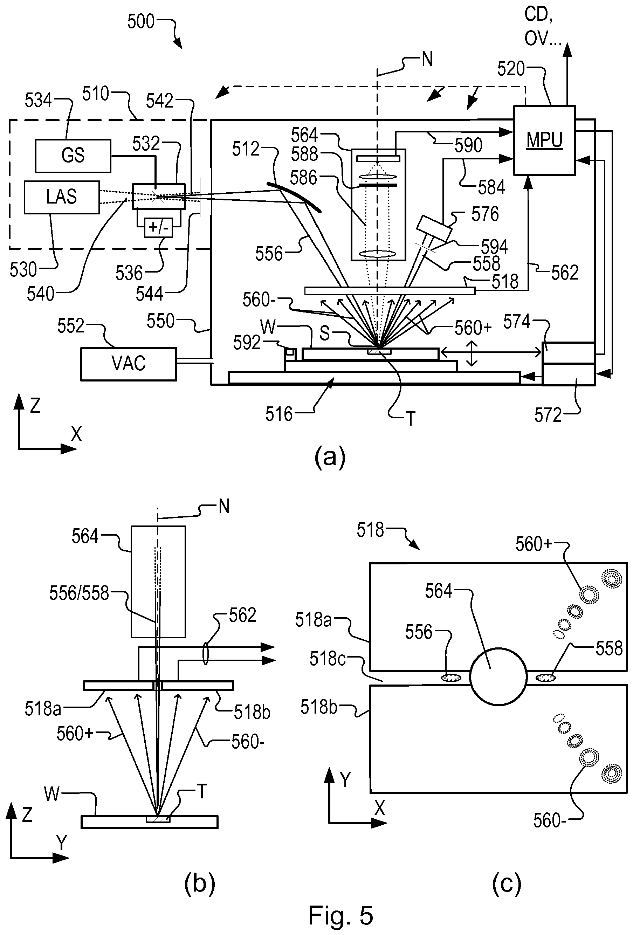

Figure 5 illustrates a schematic physical arrangement of an inspection apparatus 500 in which the spot position detection may be applied. The inspection apparatus may be a stand-alone device or incorporated in either the lithographic apparatus LA, or the lithographic cell LC. The apparatus may of course be used in conjunction with other apparatuses such as SEM apparatus, as part of a larger metrology system.

Inspection apparatus 500 is this example has the form of a scatterometer, which uses SXR radiation in normal or near-normal incidence. This inspection apparatus may be for example one of the inspection apparatuses in the hybrid metrology system 200 of Figure 2. Inspection apparatus 500 comprises a radiation source510, illumination system 512, substrate support 516, detection system 518 and metrology processing unit (MPU) 520. Radiation source 510 in this example comprises for example a generator of EUV or soft x-ray radiation based on high harmonic generation (HHG) techniques. Such sources are available for example from KMLabs, Boulder Colorado, USA (http://www.kmlabs.com/). Main components of the radiation source are a pump laser 530 and an HHG gas cell 532. A gas supply 534 supplies suitable gas to the gas cell. Optionally, the gas is ionized by an electric source 536. The pump laser may be for example a fiber-based laser with an optical amplifier, producing pulses of infrared radiation that may last for example less than 1 ns (1 nanosecond) per pulse, , and typically below 1 ps (1 picosecond). A pulse repetition rate may be up to several megahertz, as required. The wavelength of the infrared radiation may be for example in the region of 1 µm (1 micron), for example in the range 800 nm to 1500 nm. The laser pulses are delivered as a first radiation beam 540 to the HHG gas cell 532, where the gas a portion of the radiation is converted to higher frequencies the first radiation into a beam 542 including coherent radiation of the desired SXR wavelength or wavelengths.

The radiation beam 542 generated by HHG may contain multiple wavelengths. If the radiation is also monochromatic, then measurement calculations (for example reconstruction) may be simplified, but it is easier with HHG to produce radiation with several wavelengths. The volume of gas within the gas cell 532 defines an HHG space, although the space need not be completely enclosed and a flow of gas may be used instead of a static volume.

The gas may be for example a noble gas such as neon (Ne), helium (He) or argon (Ar). These are matters of design choice, and may even be selectable options within the same apparatus. Different wavelengths will, for example, provide different levels of contrast when imaging structure of different materials. For inspection of metal structures or silicon structures, for example, different wavelengths may be selected to those used for imaging features of (carbon-based) resist, or for detecting contamination of such different materials.

One or more filtering devices 544 may be provided. For example, a filter such as a thin membrane of aluminum (Al) or zirconium (Zr) may serve to cut the fundamental IR radiation from passing further into the inspection apparatus. A grating (not shown) may be provided to select one or more specific harmonic wavelengths from among those generated in the gas cell. Some or all of the beam path may be contained within a vacuum environment, bearing in mind that SXR radiation is absorbed when traveling in air. The various components of radiation source 510 and illumination system 512 can be adjustable to implement different metrology 'recipes' within the same apparatus. For example, different wavelengths and/or polarization can be made selectable. The prior publications mentioned in the introduction provide more guidance on the selection of wavelengths for different metrology tasks and target types.

From the first radiation source 510, the filtered beam 542 enters an inspection chamber 550 where the substrate W including a structure of interest is held for inspection by substrate support 516. A target structure is labeled T. The atmosphere within inspection chamber 550 is maintained near vacuum by vacuum pump 552, so that EUV radiation can pass without undue attenuation through the atmosphere. The Illumination system 512 has the function of focusing the radiation into a focused beam 556, and may comprise for example one or more two-dimensionally curved mirrors, or a series of one-dimensionally curved mirrors, as described in US 2017184981 A1, mentioned above. The focusing is performed to achieve a round or elliptical spot less than 10 µm in diameter, when projected onto the structure of interest. Substrate support 516 comprises, for example, an X-Y translation stage and a rotation stage, by which any part of the substrate W can be brought to the focal point of beam to in a desired orientation. Substrate support 516 may also be movable in the Z direction, to bring a target into the plane of focus of illumination system 512. Thus, the radiation spot S is formed on the structure of interest. Tilting of the substrate in one or more dimensions may also be provided.

Diffracted and scattered radiation 560+/560- is captured by detector 518 and captured data 562 is provided to processor 520 for use in calculating a property of the target structure T. The illumination system 512 and detection system 518 thus form an inspection apparatus. Inspection apparatus 500 in this example uses SXR radiation at normal incidence or near-normal incidence to perform diffraction-based measurements of properties of the target T. Another inspection apparatus may comprise an SXR spectroscopic reflectometer of the kind described in US2016282282A1. If it is desired to implement a hybrid metrology system, it may be assumed that components such as the metrology processor 520, position controller 572 and sensors 574 are shared between the first and second inspection apparatuses. US 2017184981 A1 describes how pump laser 530 can be shared between two HHG radiation sources. The contents of those earlier patent applications are hereby incorporated herein by reference.

To aid the alignment and focusing of the spot S with desired product structures, inspection apparatus 500 also provides a spot position sensor which may be implemented by various components under control of metrology processor 520. One of these components is an alignment camera 564, comprising an objective lens, imaging lens and an image sensor such as a CCD. The operation of spot position sensor is based at least partly on second harmonic generation as described above. The operation of the spot position sensor will be described in more detail after the example inspection apparatus has been described. Metrology processor 520 can also communicate with a position controller 572 which operates the translation stage and rotation stages. Processor 520 receives highly accurate feedback on the position and orientation of the substrate, via sensors. Sensors 574 may include interferometers, for example. In the operation of the inspection apparatus 500, captured data 562 from detection system 518 is delivered to metrology processing unit 520.

The illuminating radiation beam 556 is reflected and scattered according to the properties and orientation of the target structure T, and the angle of incidence of the beam. Radiation beam 556 is at least partially reflected into a zero order beam 558 which is optionally dumped, or may be detected by a zero-order detection system 576. Zero order detection system 576 provides zero-order captured data 584 to MPU 520. In principle, asymmetry or other parameters of interest can be measured from zero order reflection spectra, but asymmetry information will be stronger in the higher order diffracted beams 560+ and 560- which are diffracted at angles either side of the reflection axis R, as shown. Higher order diffracted beams may be any combination of first, second, third etc. diffraction orders. For simplicity, we shall refer simply to the "higher order" or "first order" beams, without signifying any limitation. The relative angles of the different orders will depend in a known manner on the wavelength(s) of the radiation and the spatial period of grating structures present in the target. The angles shown in the drawing are purely for illustration of the principle.

A simple method of metrology may include using captured data 562 representing higher order diffraction spectra from a periodic structure to measure asymmetry in the structure. The structure may be one of a plurality of biased gratings. As is known from diffraction based overlay at visible wavelengths, the asymmetry can be calculated by comparing the intensity of opposite portions of the diffraction spectrum, for example by comparing +1 and -1 order diffracted radiation. The detection system 518 in the illustrated example captures both diffracted beams 560+ and 560- simultaneously. Within detection system 518, there may be a single radiation-detecting element for each beam 560+/560-, or there may be an array of detecting elements, such as a 1- or 2-dimensional array of pixels. A single image sensor may extend so as to capture both beams 560+ and 560- on different regions of pixels. In the case of a target having periodicity in the Y direction (into the plane of the drawing), diffracted beams will be directed at similar angles into and out of the page. Detection system 518 can be arranged to capture these diffracted beams also.

Figure 5 (b) and (c) present other views of the detection system in one example implementation. As seen in the side and top views (b) and (c), detection system 518 in this example extend either side of the normal axis N, defined by the plane of substrate W and target T. Detection system 518 in this case may comprise separate detector arrays 518a, 518b with a space 518c between them for the passage of the illuminating beam 556 and zero order beam 558. Alternatively, detection system 518 may comprise a single 2-dimensional image sensor, with apertures formed in it to allow passage of the illuminating beam 556 and zero order beam 558. The detector array or arrays are placed where they will capture a far-field scatter pattern (diffraction spectrum) from the interaction of the illuminating radiation and the target. In other configurations, detectors may have more than two arrays, and these may be tilted relative to the plane of the substrate (or even curved), so as to capture a greater portion of radiation scattered by the target.

As illustrated in the top view (c), the target grating may be oriented at an angle to the axis of the space so that the higher order diffraction signals fall at an angle across the detector arrays 518a, 518b, and are not lost in the space 518c. The target grating in the illustrated example is assumed to be a one-dimensional grating with direction of periodicity aligned to the Y axis, transverse to the direction of incidence. In this way, a symmetrical diffraction pattern is captured on the detector arrays 518a, 518b. This is convenient, but not essential. With different orientations, and with two-dimensional target structures, the diffraction pattern will become more complex than the one shown here.

The alignment camera 564 is shown in its position on the normal axis N, between the incident and reflected beams. The various components can be any size, in principle. For example, the detector arrays 518a, 518b may be a few millimeters or some tens of millimeters long and wide. The space 518c may be less than a millimeter, according to the dimensions of the beams 556 and 558. If necessary, a relay lens can be used to relieve constraints on the placing of the alignment camera and detector arrays in a volume close to the target. Also, it may be convenient if part of the alignment camera is located outside the vacuum chamber.

In the configuration shown in Figure 5, the angle of incidence of the illuminating radiation is asymmetrical with respect to the normal axis N. The opposite portions of the diffraction spectrum are therefore found asymmetrically either side of the zero-order beam 558, which is also asymmetrical with respect to the normal axis. Processing of the asymmetrical signals can be adapted either by calibration with known structures or other means, to discriminate between asymmetry of the target and asymmetry of the measurement configuration.

It will be noted that the diffracted beams 560+, 560- have multiple components. These are each the result of a single +1 or -1 order diffracted beam 560+ or 560-, but for a different wavelength of radiation included within the illuminating beam 556. In the case of an HHG radiation source, typically multiple harmonic wavelengths will be excited in the gas. In addition to seeing regions corresponding to first order diffraction at different wavelengths, the image sensor in practice may also capture multiple diffraction orders for a single wavelength (+/2, +/-3, ...), and/or a combination of multiple diffraction orders for multiple wavelengths.

While the present disclosure presents SXR radiation between 1-100 nm as an example of particular interest for current technological development, shorter wavelengths in the harder x-ray range, less than 1 nm and potentially less than 0.1 nm. While inspection by reflection of radiation is described by way of example, the principles of the present disclosure may also be applied in transmissive arrangements, particularly where shorter x-ray radiation can penetrate through the whole substrate.

Now recalling the principles of spot position detection illustrated in Figure 4, the inspection apparatus of Figure 5 implements a method of determining the position of a spot of SXR radiation, without imaging the spot directly. According to this example, first radiation (laser radiation 540) is focused at a source location (marked by 'x' in gas cell 532) so as to generate second radiation (SXR radiation 542) by higher harmonic generation in a medium, such as a gas, provided at the source location. The first radiation may have a wavelength or wavelengths in an infrared (IR) range, such as the 800 to 15000 nm (15 µm), or 800 to 2200 nm, or 800 to 1500 nm. The second radiation may include wavelengths shorter than 100 nm, optionally, shorter than 50 nm, and/or shorter than 20 nm. The second radiation may include wavelengths longer than 0.1 nm or longer than 1 nm. A range of harmonics may be present in the second radiation.

An illumination optical system (512) is used to focus the second radiation into a useful spot S of second radiation by imaging the source location at a target location. As mentioned already, the illumination optical system for such wavelengths will comprise exclusively or primarily reflective optical elements, such as curved mirrors.

For determining the position of the spot S, the inspection apparatus has no optical system capable of imaging the position of the spot directly, using the second radiation. Instead, a focused spot (360) of the IR first radiation is formed at the same location as the spot of second radiation, simply by imaging the source location onto an alignment target material using the illumination optical system 512. Provided that the spot of IR radiation has sufficient intensity at its center, a spot of third radiation (362) will be generated by second harmonic generation in an interaction between the first radiation and the alignment target material. The third radiation has a wavelength half that of the IR radiation. For example, when the first radiation has a specific wavelength in the range or 800 to 2200 nm, the third radiation will have a corresponding wavelength in the range 400 nm to 1100 nm. As a more specific example, when the first radiation has a specific wavelength in the range 800 nm to 1500 nm, the third radiation will have a corresponding wavelength in the range 400 nm to 750 nm, that is visible radiation.

Being in the visible, near-UV or near-IR range, the spot of third radiation can be readily imaged using conventional focusing optics, as shown by rays 586, so that alignment camera 564 can obtain an image of the spot 462, similar to what is shown in Figure 4. Depending on the geometry, and the spectral sensitivity of the alignment camera alignment camera 564 may include a filter 588 for selecting the wavelength of the SHG radiation and blocking other wavelengths. For example a CCD-based camera is typically sensitive up to 1100 nm, which may or may not include the IR wavelength of the first radiation. Alignment image data 590 is used by MPU 520 to calculate the position of the spot of third radiation. The detected position of the spot of third radiation is then used as an indication of the position of the spot S of second (SXR) radiation. Because it can be much smaller and sharper than the IR spot 360, the position of the spot S is much more accurately represented. Alignment image data 594 can be used also to position targets T for measurement operations, in normal operation of the inspection apparatus.

In addition to the ability to be tuned to a particular size, the SHG spot has, compared with the IR spot 360, a sharply defined edge that can be imaged. The size of the SHG spot 462 is completely determined by the above described second harmonic generation process, and not limited by the diffraction limit of the focusing optics or alignment camera. In practice, the size of the imaged spot will be determined by the resolving power of the imaging system used for alignment (alignment camera 564 in this example). Another advantage of using SHG radiation is that it is not generated in the HHG source, where only the odd harmonics, particularly higher harmonics such as 7^{th}, 9^{th}, 11^{th} etc., are predominant. Therefore it is easy to arrange that the detection of the spot position is performed without interference from other signals, and vice versa.

The detection of the spot of third radiation can be used for detecting the position of the spot S in the X and Y directions (i.e. in the plane of the substrate W), and/or in the Z (normal) direction, and/or in the direction of incidence of the beam 556. For focus measurement, the intensity of the IR beam can be tuned so that a maximum intensity and/or size of the spot of third radiation gives an indication of good focus. In the European patent application EP17155453.8, mentioned above and not published at the present priority date, an HHG source arrangement has more than one source point operating simultaneously, so as to illuminate more than one target simultaneously at the substrate W. The spot position sensor disclosed in the present application can be used to measure the position of two or more spots, using the alignment image data 590 from alignment camera 564.

The alignment target material can be material of the target T on substrate W, or other material present at a known position on the substrate. Alternatively, or in addition, a dedicated alignment target material can be provided in the form of fiducial target 592. This fiducial target may have a coating of nonlinear optical material of the type referred to above, selected to generate SHG in response to pump radiation from the laser 530.. Example materials could be for example KTP or LiNbO₃, as mentioned above. For interest, Wikipedia provides the following list of SHG materials for particular pump wavelengths:
- 800 nm: β-barium borate (BBO)
- 806 nm: lithium iodate (LiIO₃)
- 860 nm: potassium niobate (KNbO3)
- 980 nm: KNbO₃
- 1064 nm: monopotassium phosphate (KH₂PO₄, KDP), lithium triborate (LBO) and β-barium borate (BBO)
- 1300 um: gallium selenide (GaSe)
- 1319 mm KNbO₃, BBO, KIDP, potassium titanyl phosphate (KTP), lithium Maims (LNbO3), LiIO₃, and ammonium dihydrogen phosphate (ADP)
- 1550 nm: potassium titanyl phosphate (KTP), lithium niobate (LiNbO)

Second harmonic generation within such materials happens because they have a non-zero 2^{nd}-order susceptibility, due to their non-inverse symmetric structure. While the above materials may be ideal ones for optimizing SHG conversion efficiency at a particular pump wavelength, it will be understood that optimization of SHG conversion need not be a priority for the purposes of the alignment sensor. The only requirement is that a small spot of SHG radiation is detectable by the alignment camera. Therefore, as mentioned, special nonlinear materials may not be required to obtain SHG at the material interface, and materials arising within normal processing of substrates may be sufficient to serve as the alignment target.

There are different ways to ensure sufficient IR radiation reaches the alignment target to generate the desired spot of SHG radiation.

Although the drawing Figure 5(a) shows the IR radiation 542 being blocked by filter 544, sufficient IR radiation may be admitted to the illumination system for the SHG effect to be used in the spot position sensor during normal operation. Alternatively, the filter 544 may be adjustable or removable under control of MPU 520, to allow operation of the spot position sensor at specific times. An additional IR-blocking filter 594 may be included in the path of zero-order beam 558, so that the IR radiation used for spot position measurement does not interfere with the SXR radiation measurement, or cause damage to the zero-order detection system 576. Again, this filter can be present permanently, or adjustable, or removable under control of MPU 520. SXR radiation, on the other hand is automatically filtered by the refractive optical elements of alignment camera 564.

From the above, it will be appreciated that the spot position sensor includes the alignment camera 564 and software within MPU 520, as well as suitable control functions and actuators that may be necessary for adjusting the IR filters 544, 594 and/or switching them in and out of the beam paths. MPU 520 may also be able to command adjustment of the laser beam 540 intensity itself, instead of or in addition to adjusting the filters 544, 594. One option for this is by controlling the laser energy. Besides that, the intensity can also be controlled by changing the focal spot size and/or profile of the laser beam and/or by changing the pulse duration. Within the above principles, various methods of operation of the spot position sensor are available.

In a first method, spot position is measured using a reference target as the alignment target. To do this, fiducial target 592 is moved into position at the target location of the illumination system 512. The first radiation is admitted to the illumination system 512, and the spot of SHG radiation is detected by the alignment camera. If the whole apparatus system is sufficiently rigid, and the position of the source point is sufficiently stable, it can be that measuring of the beam center is only required occasionally, or even only during initial alignment of the apparatus. Once the position of the center of the IR beam is found and imaged by the alignment camera 564, this position can be stored. During measurements of targets T, the targets can be imaged using the same alignment camera and aligned to the stored position.

In another type of method, measurement of spot position can be made more frequently, even once per target measurement or continuously during measurements. This could be advantageous if the apparatus is not sufficiently rigid, or for example if the source location is not sufficiently stable due for example to beam pointing error. The implementer can decide whether to align the center of the beam more often, for example for every target, or every nth target.

In this case, it may be more convenient to arrange that SHG radiation is generated directly using material on the substrate as the alignment target, such as the surface of an SiO₂ feature. A number of configurations and measurement sequences can be thought of in such an implementation. Optionally, if the measurement is not too frequently required, one could turn off the gas supply 530 so that no SXR is generated. Optionally, the additional IR blocking filter is inserted in the zero-order beam 558. Then we can adjust or remove the IR suppression filter 544 to admit sufficient IR radiation 540 into the illumination system 512. Now SHG is taking place on or in the alignment target and it can be imaged.. After alignment image data 590 has been captured, if the gas jet was turned off then it is turned on again and the IR suppression by filter 544 is restored. In this example, it is assumed that measurements using the SXR radiation are interrupted, if only very briefly, for operation of the spot position sensor. If measurement is frequently required, a switchable filter 544 can be implemented as a rotating filter wheel. For finer tuning capabilities, a continuously variable filter can be implemented, for example by a graded filter or by rotating polarizers.

In another type of implementation, the IR suppression filter 544 can be omitted, or tuned in such a way that SHG generation always takes place at the target, even during measurements. Where the zero-order detection system 576 is present, the IR suppression filter 594 in the zero-order beam 558 is used to remove the IR radiation from the zero-order detection system 576. The lenses used for imaging the SHG light at the alignment camera 564 automatically block any SXR radiation emanating from the target. IR radiation can be filtered in the alignment camera at 588, if required. IR visible can also be filtered before reaching the detector 318, for example by a zirconium layer or other spectral filter. The filter (not shown in Figures 5) may be a layer integrated with the detector arrays 318a, 318b.The spectral filter may also block the visible (SHG) radiation.

Tuning of IR intensity can be set initially in a set-up procedure, or it can be controlled automatically by the MPU 520 to optimize the size and intensity of the SHG radiation spot over time, and/or over different alignment targets. The settings of the spot position sensor can be set as part of a metrology recipe, to reduce the overhead for such optimization.

Alignment camera 564 can be used for other purposes, and may be part of another inspection apparatus in its own right. For example, if a hybrid metrology system includes the inspection apparatus 500 and a more conventional scatterometer working in IR, UV or visible wavelengths, the function of the alignment camera 564 may be served by optical elements and image sensors already present as part of that scatterometer.

The spot position sensor can be used only to control positioning of a target at a target location, or it may be used to control the positioning of the source location within radiation source arrangement 310 and/or to control focusing elements of the illumination optical system 312.

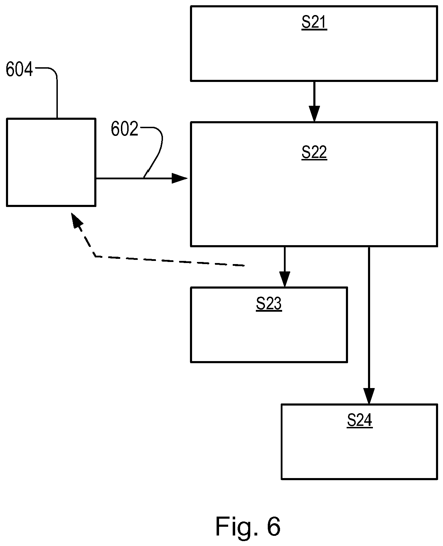

Figure 6 is a simple flowchart providing an overview of the application an inspection apparatus such as inspection apparatus 500, in the control of a lithographic manufacturing system of the type illustrated in Figure 1. The steps will be listed here, and then explained in more detail:
S21: Process wafer to produce structures on substrate
S22: Measure CD, overlay and/or other parameter across substrate, using spot position sensor as necessary
S23: Update metrology recipe
S24: Update lithography and/or process recipe

At step S21, structures are produced across a substrate using the lithographic manufacturing system. At S22, the metrology apparatus 140, including SXR inspection apparatus 500 and optionally including other metrology apparatus and information sources, are used to measure a property of the structures across the substrate. In accordance with the principles of the present disclosure, set forth above, positioning of target structures in relation a spot of SXR radiation is controlled using position information 602 measured using SHG radiation generated in an alignment target. A step 604 of operating the spot position sensor can be performed only in a set-up phase, or infrequently between measurements, or frequently between or during measurements, as required.

At step S23, optionally, metrology recipes and calibrations of the SXR inspection apparatus and any other metrology apparatus are updated in light of the measurement results obtained. The recipe may specify settings of the laser radiation delivery system also, for example to control polarization of the SXR radiation. The recipe may specify operating parameters of the spot position sensor.

At step S24, measurements of overlay or other performance parameters are compared with desired values, and used to update settings of the lithographic apparatus and/or other apparatus within the lithographic manufacturing system. By providing an inspection apparatus that can measure many targets with accurate and rapid measurement of SXR spot position, more measurements can be obtained for a given measurement overhead. This in turn can lead to better performance when the results of measurements are applied in further measurements and in further control of the lithographic apparatus.

Further embodiments are defined in the subsequent numbered clauses:
1. An apparatus for determining the position of a spot of radiation, the apparatus comprising:
   - a radiation source arrangement operable to focus first radiation at a source location so as to generate second radiation in a medium provided at the source location;
   - an illumination optical system operable to focus said second radiation into said spot at a target location; and
   - a spot position sensor for measuring the position of said spot,
   wherein said spot position sensor is arranged to use said illumination optical system to form a focused spot of said first radiation onto an alignment target material and thereby to cause a spot of third radiation to be generated by second harmonic generation in an interaction between the first radiation and the alignment target material, the spot of third radiation being used to indicate the position of the spot of second radiation.
2. An apparatus as defined in clause 1 wherein the second radiation includes wavelengths less than 100 nm.
3. An apparatus as defined in clause 1 or 2 wherein the illumination optical system is operable to focus said spot of second radiation to less than 10 µm in diameter.
4. An apparatus as defined in clause 1, 2 or 3 wherein said first radiation has a wavelength in the range 800 nm to 1500 nm, the third radiation having a wavelength in the range 400 nm to 750 nm.
5. An apparatus as defined in any preceding clause further including a filter arrangement for reducing the amount of first radiation reaching the target location.
6. An apparatus as defined in clause 5 wherein said filter arrangement is operable to increase the amount of first radiation reaching the target location temporarily for operation of said spot position sensor.
7. An apparatus as defined in any preceding clause further including an arrangement for adjusting the intensity of first radiation reaching the target location, thereby to adjust a diameter of the spot of third radiation generated by second harmonic generation.
8. An apparatus as defined in any preceding clause wherein said spot position sensor comprises a camera for imaging a region around the target location and a processor for recognizing the position of the spot of third radiation in an image of the target location obtained by said camera.
9. An apparatus as defined in any preceding clause further comprising:
   - a positioning system for holding a target at said target location by controlling of the relative position of the target and said spot, wherein said controlling is based at least partly on a position of the spot of third information detected by the spot position sensor.
10. An apparatus as defined in clause 9 wherein said positioning system includes a substrate support for holding a substrate which carries one or more targets and for moving the substrate to position a selected one of said targets at said target location and to hold said at said target location.
11. An apparatus as defined in clause 10 wherein said positioning system is operable to hold a part of the substrate at said target location for use as said alignment target material.
12. An apparatus as defined in clause 10 or 11 further wherein said positioning system is operable to hold a reference target for use as said alignment target material at said target location, the alignment target material being separate from a substrate held on the substrate support.
13. An apparatus as defined in clause 12 further comprising the reference target, and wherein said reference target is also mounted on said substrate support.
14. An apparatus as defined in clause 12 or 13 wherein said reference target comprises a nonlinear optical material, whereby said second harmonic generation occurs in the nonlinear optical material.
15. An apparatus as defined in any of clauses 10 to 14 wherein said positioning system is adapted to hold a semiconductor wafer as said substrate.
16. An inspection apparatus comprising:
   - an apparatus as defined in any of clauses 9 to 15 for delivering a spot of radiation to a target; and
   - a detection system arranged to detect, at one or more detection locations, portions of said second radiation that have interacted with a target structure positioned at said target location using said positioning system.
17. An inspection apparatus as defined in clause 16 further comprising a processing arrangement for calculating a property of the target structure based at least partly on the detected portions of the second radiation.
18. An inspection apparatus as defined in clause 17 wherein said processing arrangement is further arranged to calculate a performance parameter of a process to which the substrate has been subjected, based at least partly on the calculated property of said target structure.
19. An inspection apparatus as defined in any of clauses 16 to 18 wherein said processing arrangement is operable to perform synthetic imaging based on the detected portions of second radiation.
20.An inspection apparatus as defined in any of clauses 16 to 19 wherein said detection system is without focusing elements for said second radiation.
21. An inspection apparatus as defined in any of clauses 16 to 20 wherein said detection system includes a filter arrangement for reducing the amount of said first radiation reaching said detection locations.
22.An inspection apparatus as defined in clause 21 wherein said spot position sensor and said detection system are both operable without changing the amount of said first radiation reaching the target location.
23.An inspection apparatus as defined in any of clauses 16 to 22 wherein the apparatus for delivering said spot of radiation includes a filter arrangement for reducing the amount of first radiation reaching the target location during operation of said detection system and for increasing the amount of first radiation reaching the target location for operation of said spot position sensor.
24.An inspection apparatus as defined in any of clauses 16 to 23 wherein said illumination system is operable to illuminate the target with said first radiation and second radiation at a non-normal incidence angle relative to a target plane containing the target structure, the detection locations being arrayed about an axis of reflection defined by the incidence angle and the target plane, the spot position sensor being arranged to view the target location from a direction substantially normal to the target plane.
25. A method of determining the position of a spot of radiation without imaging the spot directly, the method comprising:
   (a) focusing first radiation at a source location so as to generate second radiation in a medium provided at the source location;
   (b) using an illumination optical system to focus said second radiation into said spot of radiation at a target location;
   (c) using said illumination optical system to form a focused spot of said first radiation onto an alignment target material;
   (d) detecting the position of a spot of third radiation generated by second harmonic generation in an interaction between the first radiation and the alignment target material; and
   (e) using the detected position of the spot of third radiation as an indication of the position of the spot of second radiation.
26. A method as defined in clause 25 wherein said spot of second radiation is less than 10 µm in diameter.
27.A method as defined in clause 25 or 26 wherein said spot of third radiation is less than 10 µm in diameter.
28.A method as defined in any of clauses 25 to 27 wherein said first radiation has a wavelength in the range 800 nm to 1500 nm, the third radiation having a wavelength in the range 400 nm to 750 nm.
29.A method as defined in any of clauses 25 to 28 wherein said second radiation is generated by higher harmonic generation in said medium, said second radiation having a wavelength shorter than 100 nm.
30. A method as defined in any of clauses 25 to 29 wherein a filter arrangement is used to reduce the amount of first radiation reaching the target location.
31. A method as defined in clause 30 wherein said filter arrangement is used to increase the amount of first radiation reaching the target location temporarily for determining the position of said spot and then to reduce it for operations using the spot of second radiation.
32.A method as defined in any of clauses 25 to 31 further including adjusting the intensity of first radiation reaching the target location, thereby to adjust a diameter of the spot of third radiation generated by second harmonic generation.
33.A method as defined in any of clauses 25 to 32 wherein step (d) uses a camera for imaging a region around the target location and step (e) uses a processor for recognizing the position of the spot of third radiation in an image of the target location obtained by said camera.
34. A method as defined in any of clauses 25 to 35 further comprising:
   (f) using the determined position of the spot of second radiation to control positioning of a target at said target location.
35.A method of inspecting structures that have been formed on a substrate by a manufacturing process, the method comprising:
   illuminating a target structure with a spot of radiation including wavelengths shorter than 100 nm by steps (a) to (f) of a method as defined in clause 28;
      (g) detecting, at one or more detection locations, portions of said second radiation that have interacted with the target structure; and
36. A method as defined in clause 35 further comprising:
   (h) calculating a property of the target structure based at least partly on the detected portions of the second radiation.
37.A method of manufacturing devices, the method including a lithographic process step, wherein, before or after performing said lithographic process step, measurements are obtained of one or more target structures on a substrate by a method as defined in clause 35 or 36 and wherein the obtained measurements are used to adjust parameters of the lithographic process step for the processing of the substrate and/or further substrates.

While embodiments of the metrology target and method have mostly been described in the terms of overlay measurement, similar techniques can be applied to measure one or more additional or alternative patterning process parameters. For example, appropriately designed metrology targets may be used to measure exposure dose variation, or measure focus/defocus, all based on asymmetry difference between pairs of biased gratings. Using the same detectors and different signal processing, other types of measurement can be made. For example, CD (linewidth) measurements can be deduced by synthetic imaging, or by reconstruction.: work completely different. In the example inspection apparatus of Figure 5, we can capture data representing scattered and diffracted radiation using the higher order detector 318, and/or spectrally resolved reflected radiation using the zero-order detector 576. By modeling the diffraction of radiation, and comparing the signals captured from a real target, values for the parameters of interest (POIs) can be determined. Typical parameters of interest in semiconductor lithography include: pitch of the grating, side wall angle or thickness of a specific layer.

While the target structures described above are metrology targets specifically designed and formed for the purposes of measurement, in other embodiments, properties may be measured on targets which are functional parts of devices formed on the substrate. Many devices have regular, periodic structures akin to a grating. The term "target", "grating" or "periodic structure" of a target as used herein does not require that the applicable structure has been provided specifically for the measurement being performed. Further, pitch P of the gratings in the metrology target may be larger than the dimension of typical product features made by a patterning process in the target portions C. On the other hand, a principal benefit of SXR metrology is that features of the metrology target can be made similar in dimension to the product features produced by advanced lithographic techniques, including for example by EUV lithography.

In association with the physical structures of the targets as realized on substrates and patterning devices, an embodiment may include a computer program containing one or more sequences of machine-readable instructions and/or functional data describing the method of determining spot position using SHG radiation, and/or describing a method of measuring a target on a substrate, and/or describing a method of analyzing a measurement to obtain information about a patterning process. This computer program may be executed for example within metrology processing unit MPU 520 in the apparatus of Figures 2 to 5 and/or the control unit LACU of Figure 1. There may also be provided a data storage medium (e.g., semiconductor memory, magnetic or optical disk) having such a computer program stored therein. Where an existing inspection apparatus, for example a dark-field imaging scatterometer of the type described in the prior publications mentioned above, is already in place and usable as the alignment camera of a spot position sensor, an embodiment can be implemented by the provision of an updated computer program product for causing a processor to perform one or more of the methods described herein. (e.g., to measure the X-Y position and/or focus of a spot of SXR radiation without directly imaging the SXR radiation, as described herein). The program may optionally be arranged to control the optical system, substrate support and the like to perform a method of measuring a parameter of the patterning process on a suitable plurality of targets (e.g., to measure asymmetry on a suitable plurality of targets and/or to determine overlay error). The program can update a parameter of the patterning process and/or of the metrology recipe, for measurement of further substrates. The program may be arranged to control (directly or indirectly) the lithographic apparatus for the patterning and processing of further substrates.

Although specific reference may have been made above to the use of embodiments in the context of optical lithography, it will be appreciated that embodiments of the invention may be used in other applications, for example imprint lithography, and where the context allows, is not limited to optical lithography. In imprint lithography, a topography in a patterning device defines the pattern created on a substrate. The topography of the patterning device may be pressed into a layer of resist supplied to the substrate whereupon the resist is cured by applying electromagnetic radiation, heat, pressure or a combination thereof. The patterning device is moved out of the resist leaving a pattern in it after the resist is cured.

The foregoing description of the specific embodiments reveals the general nature of embodiments of the invention such that others can, by applying knowledge within the skill of the art, readily modify and/or adapt for various applications such specific embodiments, without undue experimentation, without departing from the general concept of the present invention. Therefore, such adaptations and modifications are intended to be within the meaning and range of equivalents of the disclosed embodiments, based on the teaching and guidance presented herein. It is to be understood that the phraseology or terminology herein is for the purpose of description by example, and not of limitation, such that the terminology or phraseology of the present specification is to be interpreted by the skilled artisan in light of the teachings and guidance.

The breadth and scope of the present invention should not be limited by any of the above-described exemplary embodiments, but should be defined only in accordance with the following claims and their equivalents.

## Claims

1. An apparatus for determining the position of a spot of radiation, the apparatus comprising:
- a radiation source arrangement operable to focus first radiation at a source location so as to generate second radiation in a medium provided at the source location;
- an illumination optical system operable to focus said second radiation into said spot at a target location; and
- a spot position sensor for measuring the position of said spot,
wherein said spot position sensor is arranged to use said illumination optical system to form a focused spot of said first radiation onto an alignment target material and thereby to cause a spot of third radiation to be generated by second harmonic generation in an interaction between the first radiation and the alignment target material, the spot of third radiation being used to indicate the position of the spot of second radiation.

2. An apparatus as claimed in claim 1 wherein at least one of the second radiation includes wavelengths less than 100 nm, said first radiation has a wavelength in the range 800 nm to 1500 nm and the third radiation having a wavelength in the range 400 nm to 750 nm.

3. An apparatus as claimed in claim 1 or 2 wherein the illumination optical system is operable to focus said spot of second radiation to less than 10 µm in diameter.

4. An apparatus as claimed in any preceding claim further including a filter arrangement for reducing the amount of first radiation reaching the target location.

5. An apparatus as claimed in claim 4 wherein said filter arrangement is operable to increase the amount of first radiation reaching the target location temporarily for operation of said spot position sensor.

6. An apparatus as claimed in any preceding claim further including an arrangement for adjusting the intensity of first radiation reaching the target location, thereby to adjust a diameter of the spot of third radiation generated by second harmonic generation.

7. An apparatus as claimed in any preceding claim wherein said spot position sensor comprises a camera for imaging a region around the target location and a processor for recognizing the position of the spot of third radiation in an image of the target location obtained by said camera.

8. An apparatus as claimed in any preceding claim further comprising:
- a positioning system for holding a target at said target location by controlling of the relative position of the target and said spot, wherein said controlling is based at least partly on a position of the spot of third information detected by the spot position sensor.

9. An apparatus as claimed in claim 8 wherein said positioning system includes a substrate support for holding a substrate which carries one or more targets and for moving the substrate to position a selected one of said targets at said target location and to hold said at said target location.

10. An apparatus as claimed in claim 9 wherein said positioning system is operable to hold a part of the substrate at said target location for use as said alignment target material.

11. An apparatus as claimed in claim 9 or 10 further wherein said positioning system is operable to hold a reference target for use as said alignment target material at said target location, the alignment target material being separate from a substrate held on the substrate support.

12. An apparatus as claimed in claim 11 further comprising the reference target, and wherein said reference target is also mounted on said substrate support.

13. An apparatus as claimed in claim 11 or 12 wherein said reference target comprises a nonlinear optical material, whereby said second harmonic generation occurs in the nonlinear optical material.

14. An inspection apparatus comprising:
- an apparatus as claimed in any of claims 8 to 13 for delivering a spot of radiation to a target; and
- a detection system arranged to detect, at one or more detection locations, portions of said second radiation that have interacted with a target structure positioned at said target location using said positioning system.

15. A method of determining the position of a spot of radiation without imaging the spot directly, the method comprising:
(a) focusing first radiation at a source location so as to generate second radiation in a medium provided at the source location;
(b) using an illumination optical system to focus said second radiation into said spot of radiation at a target location;
(c) using said illumination optical system to form a focused spot of said first radiation onto an alignment target material;
(d) detecting the position of a spot of third radiation generated by second harmonic generation in an interaction between the first radiation and the alignment target material; and
(e) using the detected position of the spot of third radiation as an indication of the position of the spot of second radiation.
